# EUROPEAN PATENT APPLICATION

(11) **EP 3 813 501 A1**
(43) Date of publication of application: **28.04.2021**
(21) Application number: 19834681.9
(22) Date of filing: 01.07.2019
(51) Int. Cl.: H05K 7/20

(54) **HEAT DISSIPATION DEVICE**

(30) Priority: 12.07.2018 CN 201821109587 U
(71) Applicant: ZTE Corporation, Shenzhen, Guangdong 518057 (CN)
(72) Inventor: ZHOU, Ailan, Shenzhen, Guangdong 518057 (CN); YANG, Hongliang, Shenzhen, Guangdong 518057 (CN); ZHANG, Jinchuan, Shenzhen, Guangdong 518057 (CN)
(74) Representative: Betten & Resch
(86) International application number: PCT/CN2019/094206
(87) International publication number: WO 2020/011045

(57) **Abstract**

A heat dissipation device, the heat dissipation device comprising: a heat generation mechanism, a heat conduction mechanism, and a heat dissipation mechanism, the heat conduction mechanism comprising: a heat conduction layer and a filling layer; the heat generation mechanism is provided on the heat dissipation mechanism; the heat conduction mechanism is provided between the heat generation mechanism and the heat dissipation mechanism, and the heat conduction mechanism is in contact with the heat generation mechanism and with the heat dissipation mechanism; the filling layer is not in contact with the heat generation mechanism; and the filling layer transfers the heat of a heat conduction and temperate equalization layer to the heat dissipation mechanism.

## Description

### TECHNICAL FIELD

The present disclosure relates to, but is not limited to, the technical field of heat dissipation.

### BACKGROUND

With the development of the wireless communication technology from the 2nd-Generation wireless telephone technology (2G) network to the 4th-Generation mobile communication technology (4G) network and the 5th-Generation mobile communication technology (5G) network that will soon be put into use, the wireless communication technology requires faster transmission speed and greater output power. However, faster transmission speed and greater output power cause a significant increase in the heat consumption of the outdoor communication base station system (for example, the output power is increased from 300W (watts) to 1500W, and the heat consumption per unit volume is increased from 20W/L (watts/liter) to 30W/L-40W/L), especially for high-power chips.

In order to provide reliable and stable heat dissipation for heat generation mechanisms such as high-power chips in outdoor communication base stations, in related technologies, it is common to arrange a temperature-uniforming heat dissipation substrate between the chip and the heat dissipation housing, so as to transfer the temperature of the center of the chip to the temperature-uniforming heat dissipation substrate through which heat is transferred to the heat dissipation housing. In this way, the purpose of heat dissipation for the chip is achieved.

### SUMMARY

In view of the above, according to a first aspect of the present disclosure, a heat dissipation device is provided, and the heat dissipation device includes: a heat generation mechanism, a heat conduction mechanism and a heat dissipation mechanism, where the heat conduction mechanism includes a heat conduction layer and a filling layer; where: the heat generation mechanism is arranged on the heat dissipation mechanism; the heat conduction mechanism is arranged between the heat generation mechanism and the heat dissipation mechanism, and the heat conduction mechanism is in contact with the heat generation mechanism and the heat dissipation mechanism, respectively; the filling layer is not in contact with the heat generation mechanism; and the filling layer is configured to transfer heat from the heat conduction layer to the heat dissipation mechanism.

According to a second aspect of the present disclosure, a heat dissipation device is provided, and the heat dissipation device includes: a heat generation mechanism, a heat conduction mechanism, a heat dissipation mechanism and a first heat transfer layer, the heat conduction mechanism including a heat conduction layer and a filling layer; where: the heat generation mechanism is arranged on the heat dissipation mechanism; the heat conduction mechanism is arranged between the heat generation mechanism and the heat dissipation mechanism, and the heat conduction mechanism is in contact with the heat dissipation mechanism; the first heat transfer layer is arranged on the heat conduction mechanism and configured to transfer heat from the heat generation mechanism to the heat conduction mechanism; and the filling layer is not in contact with the heat generation mechanism.

Optionally, the filling layer may be arranged between the heat conduction layer and the heat dissipation mechanism and/or between the heat conduction layer and the first heat transfer layer.

According to a third aspect of the present disclosure, a heat dissipation device is provided, and the heat dissipation device includes: a heat generation mechanism, a heat conduction mechanism, a heat dissipation mechanism, a second heat transfer layer and a floating mechanism, the heat conduction mechanism including a heat conduction layer and a filling layer; where, the heat conduction mechanism is arranged between the heat generation mechanism and the heat dissipation mechanism; the second heat transfer layer is arranged between the heat generation mechanism and the heat conduction layer of the heat conduction mechanism, and configured to transfer heat of the heat generation mechanism to the heat conduction layer; the filling layer is arranged between the heat conduction layer and the heat dissipation mechanism and configured to transfer heat from the heat conduction layer to the heat dissipation mechanism; the floating mechanism is configured to fixedly connect the heat conduction layer and the heat dissipation mechanism to adjust the interval between the heat conduction layer and the heat dissipation mechanism and/or the floating mechanism is configured to fixedly connect a substrate arranged on the heat generation mechanism to the heat conduction layer to reduce a gap between the heat generation mechanism and the heat conduction layer.

Optionally, both the filling layer and the second heat transfer layer are made of thermal interface material, especially elastic thermal interface material, such as thermal silica gel, heat-conducting glue, or phase interface material.

Optionally, the heat conduction layer is a temperature-uniforming heat dissipation substrate, such as an aluminum plate, a copper plate, a vapor chamber plate, or an aluminum plate with embedded heat pipe. The heat conduction layer has the function of heat conduction and temperature uniformity.

Optionally, the floating mechanism is a spring screw.

### BRIEF DESCRIPTION OF DRAWINGS

In the drawings (which are not necessarily drawn to scale), similar reference numerals may describe similar components in different views. Similar reference numerals with different letter suffixes may indicate different examples of similar components. The accompanying drawings generally show the various embodiments discussed herein by way of example and in a non-limiting manner.
Fig. 1 is a schematic structural diagram of a heat dissipation device according to an optional embodiment of the present disclosure;
Fig. 2 is a schematic structural diagram of a heat dissipation device according to another optional embodiment of the present disclosure;
Fig. 3 is a schematic structural diagram of a heat dissipation device according to another optional embodiment of the present disclosure;
Fig. 4 is a schematic structural diagram of a heat dissipation device according to another optional embodiment of the present disclosure;
Fig. 5 is a schematic structural diagram of a heat dissipation device according to another optional embodiment of the present disclosure;
Fig. 6 is a schematic structural diagram of a heat dissipation device according to another optional embodiment of the present disclosure;
Fig. 7 is a schematic structural diagram of a heat dissipation device according to another optional embodiment of the present disclosure;
Fig. 8 is a schematic structural diagram of a heat dissipation device according to another optional embodiment of the present disclosure;
Fig. 9 is a schematic structural diagram of a heat dissipation device according to another optional embodiment of the present disclosure;
Fig. 10 is a schematic structural diagram of a heat dissipation device according to another optional embodiment of the present disclosure; and
Fig. 11 is a schematic structural diagram of a heat dissipation device according to another optional embodiment of the present disclosure.

### DETAILED DESCRIPTION

The technical schemes in the embodiments of the present disclosure will be clearly and completely described below with reference to the drawings in the embodiments of the present disclosure.

In order to enable those skilled in the art to clearly understand the technical schemes of the present disclosure, the technical schemes of the present disclosure will be described in detail with reference to the drawings and specific embodiments. It should be understood that the specific embodiments and drawings are only provided for facilitating the understanding of the technical schemes of the present disclosure by those skilled in the art and shall not constitute any limitation to the technical schemes of the present disclosure. Any uncreative improvements made within the scope of the concepts of the present disclosure shall be included in the protection scope of the present disclosure.

It should be understood that the "embodiments of the present disclosure" or "the foregoing embodiments" mentioned throughout the description mean that a specific feature, structure, or characteristic related to the embodiment is included in at least one embodiment of the present disclosure. Therefore, expressions "in the embodiment of the present disclosure" or "in the foregoing embodiment" appearing in various places throughout the specification do not necessarily refer to the same embodiment. In addition, these specific features, structures or characteristics may be combined in any suitable manner in one or more embodiments.

As described above, in order to provide reliable and stable heat dissipation for heat generation mechanisms such as high-power chips in outdoor communication base stations, in related technologies, it is common to arrange a temperature-uniforming heat dissipation substrate between the chip and the heat dissipation housing, so as to transfer the temperature of the center of the chip to the temperature-uniforming heat dissipation substrate through which heat is transferred to the heat dissipation housing. In this way, the purpose of heat dissipation for the chip is achieved. However, due to the processing and installation tolerances of the chip and the temperature-uniforming heat dissipation substrate, there is a gap between the temperature-uniforming heat dissipation substrate and the chip, resulting in a large heat resistance between the chip and the temperature-uniforming heat dissipation substrate. In order to address the above problems, in related technologies, it is common to arrange a layer of interface material between the chip and the temperature-uniforming heat dissipation substrate to reduce heat resistance and improve heat transfer. However, the interface material has a relatively large thickness and a small heat conductivity, resulting in low heat transfer efficiency and poor heat dissipation effect of the chip.

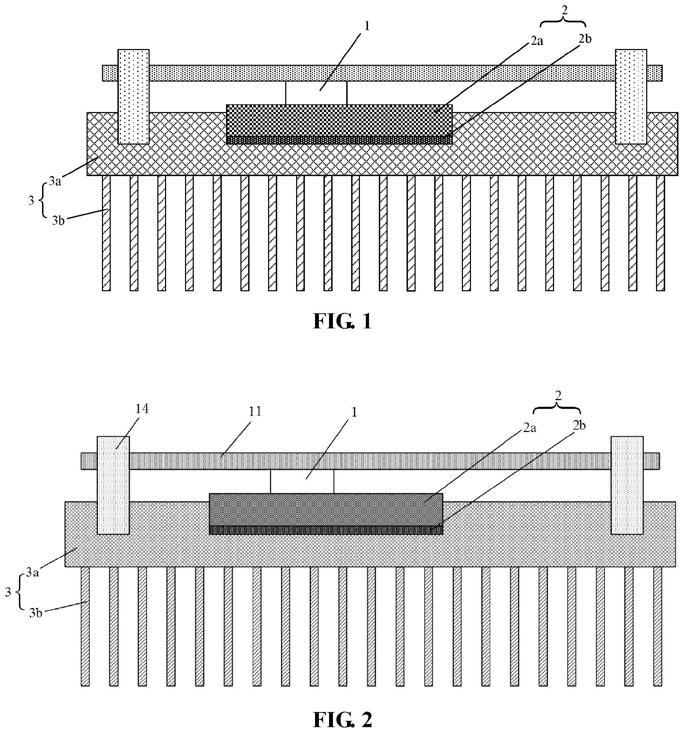

Referring to Fig. 1, an optional embodiment of the present disclosure provides a heat dissipation device including a heat generation mechanism 1, a heat conduction mechanism 2 and a heat dissipation mechanism 3. The heat conduction mechanism 2 includes a heat conduction layer 2a and a filling layer 2b. The heat generation mechanism 1 is arranged on the heat dissipation mechanism 3; the heat conduction mechanism 2 is arranged between the heat generation mechanism 1 and the heat dissipation mechanism 3, and the heat conduction mechanism 2 is in contact with the heat generation mechanism 1 and the heat dissipation mechanism 3, respectively.

In this embodiment, the heat conduction mechanism 2 is made of material with high heat conductivity. The heat conduction mechanism 2 is in contact with the heat generation mechanism 1 and the heat dissipation mechanism 3, respectively, and heat generated by the heat generation mechanism 1 is quickly transferred to the heat dissipation mechanism 3 by the heat conduction mechanism 2, thereby achieving heat dissipation of the heat generation mechanism 1. It should be understood that the heat generation mechanism 1 may be heating chips arranged on the substrate 11, for example, high-power chips used in outdoor communication base stations, Center Processing Units (CPUs), Graphic Processing Units (GPUs), etc., and the heat generation mechanism 1 may also be elements that generate heat, such as batteries and motors, or mechanisms used to dissipate heat from other devices.

In addition, the filling layer 2b is not in contact with the heat generation mechanism 1. The filling layer 2b transfers heat from the heat conduction layer 2a to the heat dissipation mechanism 3.

Here, the heat conduction layer 2a may be a heat conduction layer 2a made of heat-conducting material with high heat conductivity, for example a copper plate, a vapor chamber (VC) plate, an aluminum plate, an aluminum plate with embedded heat pipe, or a heat pipe. The filling layer 2b is made of heat-conducting material with elasticity, for example a heat-conducting pad. In some other embodiments, the filling layer 2b may also be made of indeterminate heat-conducting material, for example thermal silica gel, heat-conducting glue and the like.

It should be noted that, in Fig. 1, a case where the heat dissipation device includes one heat generation mechanism is taken as an example. It should be understood that, in this embodiment, when the heat dissipation device includes multiple heat generation mechanisms, the heat dissipation device provided in this embodiment may also be applicable. In addition, it should be noted that the heat generation mechanism 1 is arranged on the heat dissipation mechanism 3, and may be directly or indirectly arranged on the heat dissipation mechanism 3 (in Fig. 1, the heat generation mechanism 1 is indirectly arranged on the heat dissipation mechanism 3).

When the heat dissipation device includes multiple heat generation mechanisms, the thickness of the heat generation mechanisms is different due to the processing tolerances between the multiple heat generation mechanisms during processing, resulting in a gap between the heat generation mechanisms and the heat transfer mechanism, which increases the heat resistance in transferring heat generated by the heat generation mechanisms to the heat conduction mechanism. In this embodiment, as shown in Fig. 1, the heat conduction mechanism is provided to include a heat conduction layer and a filling layer which are not in contact with each other, thus after the heat generation mechanisms are arranged on the heat dissipation mechanism, the filling layer fills the gap between the heat conduction layer and the heat dissipation mechanism, so that the heat conduction layer can be tightly pressed against the heat generation mechanisms by the elastic pressing effect of the filling layer. Therefore, while making up for the processing and installation tolerances of the heat generation mechanisms and the heat conduction mechanism, the heat transfer efficiency can be improved, and the heat dissipation effect for the heat generation mechanism can be improved.

Since the heat conduction layer is made of heat-conducting material with high heat conductivity, such as a copper plate, a VC plate, an aluminum plate or heat pipe, the heat conductivity of the heat conduction layer may reach 380W/mk (watt/meter^{∗}Kelvin), so the heat conduction layer can quickly transfer heat generated by the heat generation mechanisms to the heat dissipation mechanism, which reduces the heat resistance between the heat generation mechanisms and the heat dissipation mechanism, thereby improving the transfer efficiency of heat generated by the heat generation mechanisms to the heat dissipation mechanism.

In this embodiment, as shown in Fig. 1, a notch may be formed on the surface of the heat dissipation mechanism 3, the heat conduction mechanism 2 is arranged in the notch, and the filling layer 2b is made of heat-conducting material with elasticity. In this way, when the heat conduction layer 2a is pressed against the heat generation mechanism 1, the filling layer 2b can always supply an elastic force toward the heat generation mechanism 1, so that the heat conduction layer 2a can be pressed more tightly against the heat generation mechanism 1. In addition, by arranging the heat conduction mechanism 2 in the notch, heat from the heat conduction mechanism 2 can also be transferred to the heat dissipation mechanism through a sidewall of the notch, which further improves the transfer efficiency of heat generated by the heat generation mechanism to the heat dissipation mechanism. Certainly, in this embodiment, no notch may be formed on the surface of the heat dissipation mechanism 3. In this case, the heat conduction mechanism 2 is directly arranged on the surface of the heat dissipation mechanism 3, and the filling layer 2b may also serve to press the heat conduction layer 2a against the heat generation mechanism 1 more tightly.

The heat dissipation device according to the embodiment of the present disclosure is directly brought into contact with the heat conduction mechanism with the heat generation mechanism when dissipating heat from the heat generation mechanism, but the filling layer in the heat conduction mechanism is not in contact with the heat generation mechanism, so that the heat generated by the heat generation mechanism is directly transferred to the heat conduction layer and the heat conduction layer can quickly transfer heat from the center of the heat generation mechanism to the heat dissipation mechanism, thereby improving the efficiency in conduction of heat generated by the heat generation mechanism, and improving the heat dissipation for the heat generation mechanism.

Referring to Fig. 1, in this embodiment, the heat dissipation mechanism 3 may include a heat dissipation housing 3a and a plurality of heat dissipation teeth 3b. The plurality of heat dissipation teeth 3b are arranged on the heat dissipation housing 3a and are fixedly connected to the heat dissipation housing 3a, and the plurality of heat dissipation teeth 3b are arranged away from the heat generation mechanism 1 and the heat transfer mechanism 2.

In this embodiment, the plurality of heat dissipation teeth and the heat dissipation housing may be made of the same heat-conducting material. As shown in Fig. 1, the plurality of heat dissipation teeth and the heat dissipation housing are arranged perpendicular to each other, so that the plurality of heat dissipation teeth can increase the heat dissipation area of the heat dissipation mechanism, thereby improving the heat dissipation effect and enhancing the cooling and heat dissipation effect for the heat generation mechanism. Optionally, the plurality of heat dissipation teeth may be integrally formed with the heat dissipation housing.

Based on the foregoing embodiments, in an optional embodiment of the present disclosure, referring to Fig. 2 (in Fig. 2, a case where the heat dissipation device includes one heat generation mechanism is taken as an example), the heat conduction layer 2a is arranged on the filling layer 2b.

As shown in Fig. 2, in this embodiment, the heat conduction layer 2a is in direct contact with the heat generation mechanism 1. The filling layer 2b is arranged between the heat conduction layer 2a and the heat dissipation mechanism 3.

In this embodiment, the heat generation mechanism is in direct contact with the heat conduction layer. During the installation process, due to the elastic floating effect of the filling layer, the heat conduction layer is tightly pressed against the heat generation mechanism. At the same time, because the heat conduction layer is made of heat-conducting material with high heat conductivity, for example a copper plate, a VC plate, an aluminum plate, or a heat pipe, and the heat conductivity of the heat conduction layer may reach 380W/mk, the heat conduction layer can quickly transfer heat generated by the heat generation mechanism to the heat dissipation mechanism, thereby reducing the heat resistance between the heat generation mechanism and heat dissipation mechanism, thereby improving the transfer efficiency of heat generated by the heat generation mechanism to the heat dissipation mechanism.

In addition, as shown in Fig. 2, the heat dissipation device may further include a substrate 11 and at least two fixed connecting members 14. The heat generation mechanism 1 is arranged between the substrate 11 and the heat transfer mechanism 2. One end of the at least two fixed connecting members 14 is connected to the substrate 11 and the other end thereof is connected to the heat dissipation mechanism 3. In addition, the fixed connecting member 14 may be a screw or a bolt, which can be screwed into a threaded hole formed in the heat dissipation mechanism 3 (for example, the heat dissipation housing 3a) through a hole formed in the substrate 11. The substrate 11 may be a Printed Circuit Board (PCB), and the PCB is a support for an electronic component and a carrier for electrical connection of the electronic component.

In addition, preferably, the at least two fixed connecting members 14 apply, to the substrate 11, a force toward the heat generation mechanism 1, so as to clamp the heat generation mechanism 1 and the heat conduction mechanism 2 between the substrate 11 and the heat dissipation mechanism 3. When the fixed connecting member 14 is a screw (which may be a normal screw or a spring screw), by screwing the screw down, a screw head (not shown in detail) of the screw may apply a force to the substrate 11. In this way, the elastic filling layer 2b may be further used to eliminate the processing and installation tolerances of the heat generation mechanism 1, the substrate 11, the heat conduction layer 2a, etc., and reduce the gap between the heat conduction layer and the heating layer, so that there is no use of thermal interface material between the heat conduction layer and the heating layer or only use of very thin thermal interface material, for example 0.1-0.15 mm in thickness, thereby improving the transfer efficiency of heat generated by the heat generation mechanism to the heat dissipation mechanism. This effect is particularly prominent when there are two or more heat generation mechanisms 1 corresponding to the same substrate 11. It should be understood that the substrate 11 and the heat generation mechanism 1 may be fixedly connected to each other or integrally formed. In addition, although the substrate and the fixed connecting member are shown in the drawings of the present disclosure, they are not essential. Additionally or alternatively, the effects of eliminating tolerances and reducing heat resistance can be achieved through other means such as the first fixed connecting member 10, the second fixed connecting member 13, or the second elastic connecting member 12 described below.

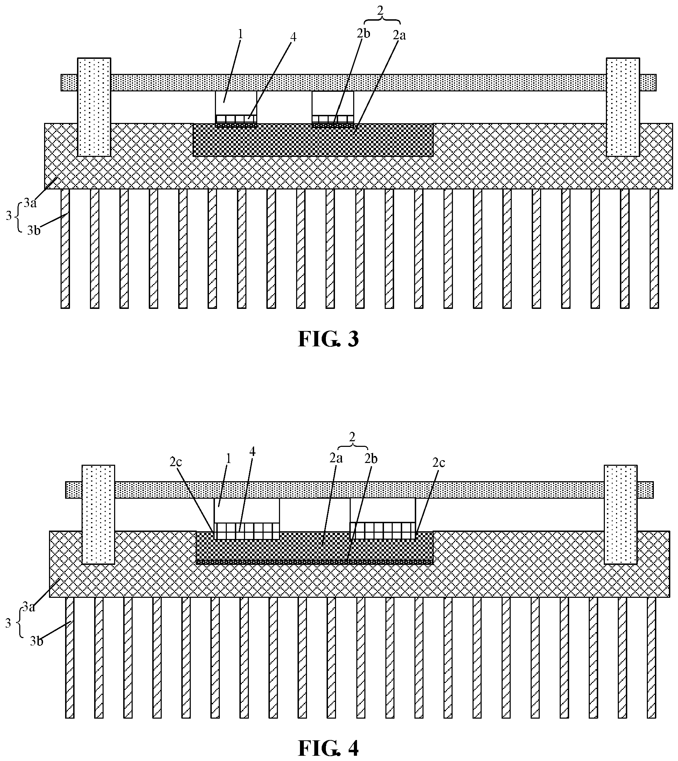

Referring to Fig. 3, in an optional embodiment of the present disclosure, the filling layer 2b is arranged on the heat conduction layer 2a. In other words, the heat conduction layer 2a is arranged between the filling layer 2b and the heat generation mechanism 1.

As shown in Fig. 3, a filling layer 2b is arranged on the heat conduction layer 2a, and a case where two heat generation mechanisms are arranged is taken as an example. The heat dissipation device in this embodiment further includes a first heat transfer layer 4. The first heat transfer layer 4 is arranged on the heat transfer mechanism 2; the first heat transfer layer 4 transfers heat from the heat generation mechanism 1 to the heat transfer mechanism 2. In other words, in this embodiment, the heat transfer mechanism 2 is not in direct contact with the heat generation mechanism 1, but transmits heat by at least the first heat transfer layer 4.

As shown in Fig. 3, in this embodiment, the first heat transfer layer 4 is in direct contact with the heat generation mechanism 1. The first heat transfer layer 4 may be made of material with high heat conductivity, such as a copper plate, a VC plate, or an aluminum plate.

It should be noted that, in this embodiment, the first heat transfer layer 4 may be made of the same material as the heat conduction layer 2a. Certainly, the first heat transfer layer 4 and the heat conduction layer 2a may be made of different material, as long as the first heat transfer layer 4 is made of material with high heat conductivity, which is not particularly limited in this embodiment.

The filling layer 2b is arranged between the heat conduction layer 2a and the first heat transfer layer 4.

Certainly, in this embodiment, the filling layer may be arranged between the heat conduction layer 2a and the heat dissipation mechanism 3; or, the filling layer may be arranged between the heat conduction layer 2a and the first heat transfer layer 4, and simultaneously (the other) the filling layer is arranged between the heat conduction layer 2a and the heat dissipation mechanism 3.

In this embodiment, when the filling layer is arranged between the heat conduction layer and the heat dissipation mechanism, the first heat transfer layer is in direct contact with the heat conduction layer, and after the installation, under the elastic action of the filling layer, the first heat transfer layer and the heat conduction layer are tightly pressed against the heat generation mechanism by the filling layer. The first heat transfer layer quickly transfers heat generated by the heat generation mechanism to the heat conduction layer, thereby reducing the heat resistance between the heat conduction layer and the heat generation mechanism, and improving the heat transfer efficiency. The heat conduction layer can quickly transfer heat generated by the heat generation mechanism to the heat dissipation mechanism, thereby reducing the heat resistance between the heat generation mechanism and the heat dissipation mechanism, thereby improving the transfer efficiency of heat generated by the heat generation mechanism to the heat dissipation mechanism.

Based on the foregoing embodiments, referring to Fig. 4 (in Fig. 4, a case where the heat dissipation mechanism includes two heat generation mechanisms is taken as an example), in an optional embodiment of the present disclosure, a groove 2c is formed on a surface of the heat conduction layer 2a close to the first heat transfer layer 4; where the first heat transfer layer 4 is arranged in the groove 2c.

As shown in Fig. 4, in this embodiment, the groove 2c is arranged directly opposite to the heat generation mechanism 1, the first heat transfer layer 4 is arranged in the groove 2c; the filling layer 2b is arranged between the heat conduction layer 2a and the heat dissipation mechanism 3. Certainly, the filling layer may be arranged in the groove 2c and arranged between the first heat transfer layer 23 and the heat conduction layer 2a.

In this embodiment, the first heat transfer layer is arranged in the groove, thereby effectively preventing the first heat transfer layer from loosening and falling off due to vibration and other reasons, and improving the stability of heat dissipation.

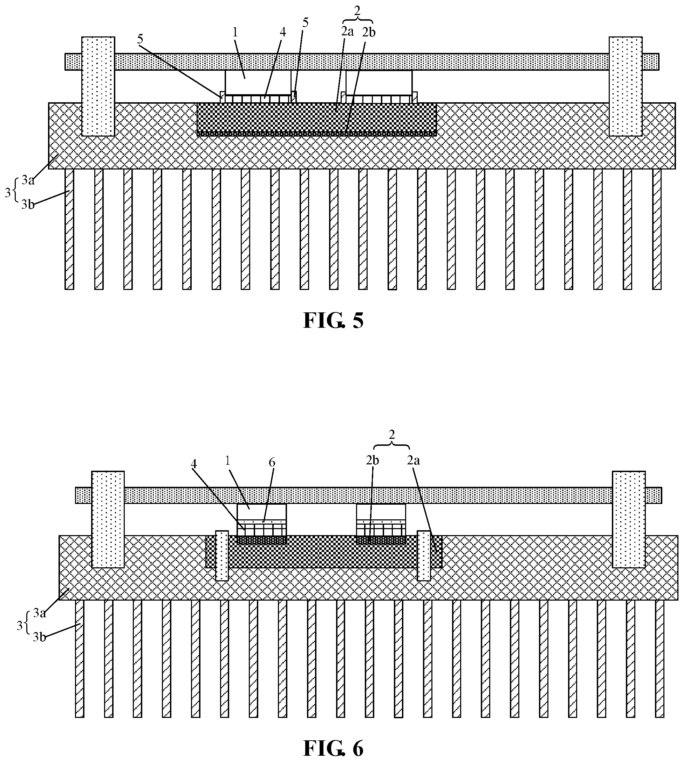

Based on the foregoing embodiments, referring to Fig. 5 (in Fig. 5, a case where the heat dissipation mechanism includes two heat generation mechanisms is taken as an example), the heat dissipation device in an optional embodiment of the present disclosure further includes at least two limiting columns 5 which are arranged on the surface of the heat conduction layer 2a close to the first heat transfer layer 4. The first heat transfer layer 4 is arranged between the at least two limiting columns 5.

As shown in Fig. 5, in this embodiment, a region between the opposite sides of the two limiting columns 5 is arranged directly opposite to the heat generation mechanism 1, and the first heat transfer layer 4 is arranged in the region between the opposite sides of the two limiting columns 5. The filling layer 2b is arranged between the heat conduction layer 2a and the heat dissipation mechanism 3. Certainly, the filling layer may be arranged in the region between the opposite sides of the two limiting columns 5 and between the first heat transfer layer 4 and the heat conduction layer 2a. In Fig. 5, a case where the filling layer 2b is arranged between the heat conduction layer 2a and the heat dissipation mechanism 3 is taken as an example. It should be noted that the filling layer 2b may also be arranged between the first heat transfer layer 4 and the heat conduction layer 2a. In this case, the filling layer 2b is arranged in the region between the opposite sides of the two limiting columns 5, and the filling layer 2b is made of heat-conducting material with certain hardness and elasticity, such as a heat-conducting pad. After installation, the elasticity of the heat-conducting pad presses the first heat transfer layer 4 tightly against the heat generation mechanism 1.

In this embodiment, the first heat transfer layer is arranged in the region between the opposite sides of the two limiting columns, thereby effectively preventing the first heat transfer layer from loosening and falling off due to vibration and other reasons, and improving the stability of heat dissipation.

Based on the foregoing embodiments, referring to Fig. 6 (in Fig. 6, a case where the heat dissipation mechanism includes two heat generation mechanisms is taken as an example), the heat dissipation device in an optional embodiment of the present disclosure further includes a second heat transfer layer 6, where the second heat transfer layer 6 is arranged on the first heat transfer layer 4; and the second heat transfer layer 6 transfers heat from the heat generation mechanism 1 to the first heat transfer layer 4.

In this embodiment, the second heat transfer layer 6 may be made of thermal interface material with high heat conductivity and relatively soft fluidity, for example heat-conducting silicone grease, heat-conducting glue, and the like. In other embodiments, the second heat transfer layer 6 may be made of elastic thermal interface material, for example an elastic heat-conducting pad.

After the installation, the second heat transfer layer 6 is tightly pressed against the heat generation mechanism 1 by the first heat transfer layer 4.

In this embodiment, the second heat transfer layer is made of thermal interface material, especially material with very soft fluidity, for example heat-conducting silicone grease, heat-conducting glue, and the like. After the second heat transfer layer is arranged between the first heat transfer layer and the heat generation mechanism, the second heat transfer layer is tightly pressed against the heat generation mechanism to reduce the heat resistance between the heat generation mechanism and the first heat transfer layer, thereby improving the transfer efficiency of heat generated by the heat generation mechanism to the heat dissipation mechanism.

It should be understood that the second heat transfer layer 6 may also be directly arranged on the heat conduction mechanism 2 and in contact with the heat conduction mechanism, that is, no first heat transfer layer 4 may be arranged. In addition, the filling layer 2b is made of thermal interface material with elasticity, for example a heat-conducting pad. In this case, the filling layer 2b is arranged between the heat conduction layer 2a and the heat dissipation mechanism 3. In other words, the heat conduction layer 2a may be in contact with the heat generation mechanism 1 and the heat dissipation mechanism 3 through the thermal interface material that is used as the second heat transfer layer 6 and the filling layer 2b, respectively. Since the heat conduction layer 2a has a temperature equalization function, it may also be called a heat-conducting temperature-uniforming layer or a temperature-uniforming heat conduction layer.

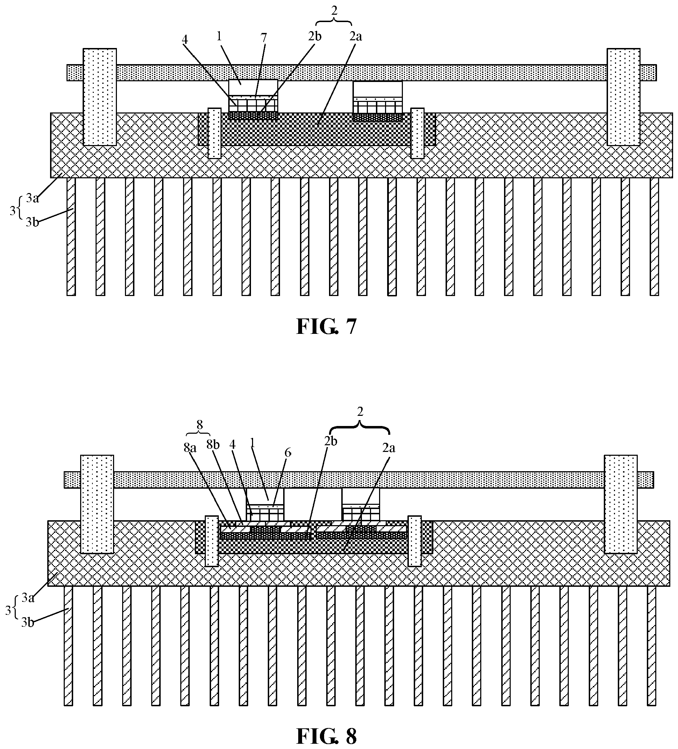

Based on the foregoing embodiments, referring to Fig. 7 (in Fig. 7, a case where the heat dissipation mechanism includes two heat generation mechanisms is taken as an example), the heat dissipation device in an optional embodiment of the present disclosure further includes an adhesive layer 7. The first heat transfer layer 4 is bonded to the heat generation mechanism 1 by the adhesive layer 7, and the adhesive layer 7 transfers heat from the heat generation mechanism 1 to the first heat transfer layer 4.

In this embodiment, the adhesive layer 7 may be heat-conducting glue. The heat-conducting glue may be one-component, heat-conducting, room-temperature curing silicone adhesive sealant. The heat-conducting glue has good resistance to cold and hot alternating performance, aging resistance and electrical insulation properties, and has good moisture resistance, shock resistance, corona resistance, electric leakage resistance and chemical resistance. It may be used continuously at -60 °C to 280 °C at maintained performance, and has good adhesion to most metal and non-metal material.

As shown in Fig. 7, in this embodiment, the first heat transfer layer is bonded to the heat generation mechanism by heat-conducting glue. In this way, the first heat transfer layer can be prevented from falling off due to vibration and other reasons, while reducing the heat resistance between the heat generation mechanism and the first heat transfer layer, improving the transfer efficiency of heat generated by the heat generation mechanism to the heat dissipation mechanism, and enhancing the cooling and heat dissipation effect for the heat generation mechanism.

Based on the foregoing embodiments, referring to Fig. 8 (in Fig. 8, a case where the heat dissipation mechanism includes two heat generation mechanisms is taken as an example), the heat dissipation device in an optional embodiment of the present disclosure further includes a heat transfer member 8. One end of the heat transfer member 8 is connected to the first heat transfer layer 4, and the other end of the heat transfer member 8 is connected to the heat conduction mechanism 2.

In this embodiment, the heat transfer member 8 includes a heat pipe; as shown in Fig. 8, the heat pipe includes an evaporation side 8b and a condensation side 8a; the evaporation side 8b of the heat pipe is connected to the first heat transfer layer 4; and the condensation side 8a of the heat pipe is connected to the first heat conduction layer 2a.

In this embodiment, the heat pipe consists of a pipe housing, a wick and an end cap. The inside of the pipe housing is pumped to a negative pressure of 1.3×10⁻¹Pa to 10⁻⁴Pa and then filled with an appropriate amount of working fluid. The working fluid may be thermal phase-change liquid. The wick is made of capillary material with multiple voids, and is tightly attached to the inner wall of the pipe housing. The working liquid fills the wick and seals it. A side where the working liquid in the heat pipe is evaporated when being heated is the evaporation side, and a side where the working liquid in the heat pipe is condensed after being cooled is the condensation side. When the evaporation side of the heat pipe is heated, the liquid in the wick evaporates and vaporizes. The steam flows to the condensation side due to a slight pressure difference and releases heat to condense into liquid. The liquid flows back to the evaporation side along the wick in the aid of the siphon force of the wick. In this cycle, heat is transferred from the evaporation side to the condensation side of the heat pipe.

In this embodiment, the evaporation side of the heat pipe is connected to the first heat transfer layer, and the evaporation side of the heat pipe and the first heat transfer layer may be connected by welding, bonding or other connection methods; the condensation side of the heat pipe is connected to the heat conduction layer, and the condensation side of the heat pipe and the heat conduction layer may be connected by welding, bonding or other connection methods. Heat from the evaporation side of the heat pipe can be quickly transferred to the condensation side of the heat pipe, and then to the heat conduction layer through the condensation side of the heat pipe, thereby reducing the heat resistance between the first heat transfer layer and the heat conduction layer, increasing the transfer efficiency of heat generated by the heat generation mechanism to the heat dissipation mechanism, and enhancing the cooling and heat dissipation effect for the heat generation mechanism.

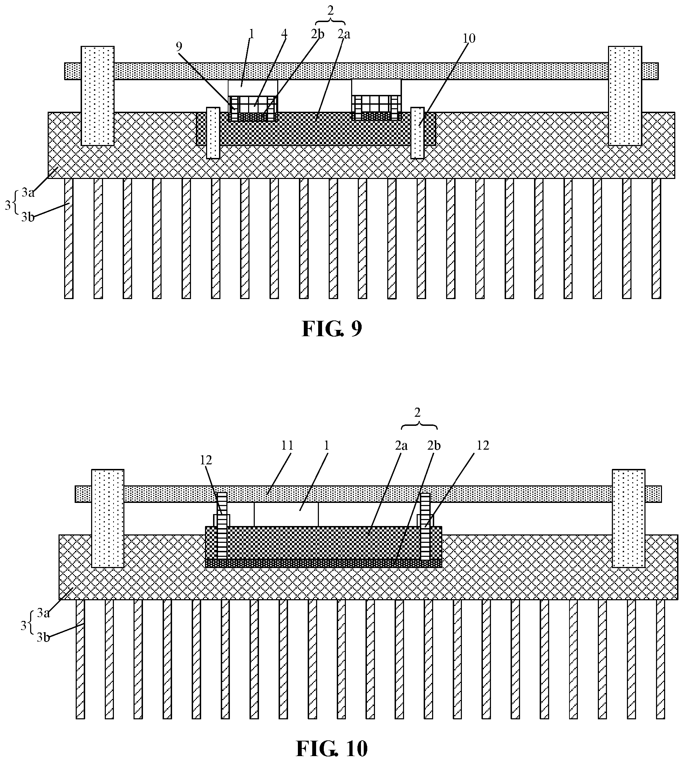

Based on the foregoing embodiments, referring to Fig. 9 (in Fig. 9, a case where the heat dissipation mechanism includes two heat generation mechanisms is taken as an example), the heat dissipation device in an optional embodiment of the present disclosure further includes at least one first elastic connecting member. In Fig. 9, each heat generation mechanism corresponding to two first elastic connecting members 9 is taken as an example, where one end of the at least one first elastic connecting member is connected to the first heat transfer layer 4, and the other end of the at least one first elastic connecting member is connected to the heat conduction layer 2a; the at least one first elastic connecting member supplies an elastic force to the first heat transfer layer 4 in a direction toward to the heat generation mechanism 1.

As shown in Fig. 9, the first elastic connecting member 9 is arranged perpendicularly to the contact surface of the heat conduction layer 2a and the first heat transfer layer 4. After the installation, the elastic force supplied by the first elastic connecting member 9 to the first heat transfer layer 4 is perpendicular to the surface of the heat generation mechanism 1 close to the heat conduction layer 2a; and the elastic force supplied by the first elastic connecting member 9 to the first heat transfer layer 4 is toward the heat generation mechanism 1. That is to say, in this embodiment, the first heat transfer layer 4 and the heat conduction layer are tightly pressed against the heat generation mechanism 1 by the effect of the first elastic connecting member 9.

As shown in Fig. 9, in Fig. 9, the filling layer 2b being arranged between the first heat transfer layer 4 and the heat conduction layer 2a is taken as an example. It should be understood that the filling layer 2b may also be arranged on the heat conduction layer 2a and the heat dissipation mechanism. 3, and, the filling layer 2b may also be arranged between the first heat transfer layer 4 and the heat conduction layer 2a and also be arranged between the heat conduction layer 2a and the heat dissipation mechanism 3. The filling layer 2b is made of thermal interface material with relatively soft fluidity, for example heat-conducting silicone grease, heat-conducting glue and the like.

In this embodiment, the first elastic connecting member may be a spring screw. After the spring screw connects two objects, it may supply an elastic force to the two objects connected by the spring screw. In this way, the first elastic connecting member 9 supplies the first heat transfer layer 4 with an elastic force toward the heat generation mechanism 1.

In this embodiment, as shown in Fig. 9, the device further includes at least two first fixed connecting members, and the at least two first fixed connecting members fix the heat conduction layer 2a on the heat dissipation mechanism 3.

In this embodiment, the first fixed connecting member 10 may be a common screw, and the first fixed connecting member 10 fixes the heat conduction layer 2a on the heat dissipation mechanism 3 through threaded holes formed on the heat dissipation mechanism 3.

In this embodiment, the first elastic connecting member is used to connect the first heat transfer layer and the heat conduction layer. After the installation, the first heat transfer layer is tightly pressed against the heat generation mechanism. In this way, the elastic force supplied by the first elastic connecting member reduces the gap between the first heat transfer layer and the heat generation mechanism, thereby reducing the heat resistance between the heat generation mechanism and the first heat transfer layer, improving the transfer efficiency of heat generated by the heat generation mechanism to the heat dissipation mechanism, and enhancing the cooling and heat dissipation effect for the heat generation mechanism.

Based on the foregoing embodiments, as shown in Fig. 10, in an optional embodiment of the present disclosure, the heat generation mechanism 1 is arranged on the substrate 11; the heat dissipation device further includes at least two second elastic connecting members; where, one end of each of the at least two elastic connecting members is connected to the heat conduction layer 2a, and the other end of each of the at least two second elastic connecting members are connected to the substrate 11; the at least two second elastic connecting members supply an elastic force to the heat conduction layer 2a in a direction toward to the heat generation mechanism 1. The filling layer 2b is made of thermal interface material with relatively soft fluidity, for example heat-conducting silicone grease, heat-conducting glue and the like.

In this embodiment, the second elastic connecting member 12 may be the same spring screw or other elastic connecting member as the first elastic connecting member.

In this embodiment, as shown in Fig. 10, the second elastic connecting members 12 are arranged at both ends of the heat conduction layer 2a, and the second elastic connecting members 12 are arranged perpendicularly to the surface of the heat conduction layer 2a close to the substrate 11. The connecting member 12 supplies the heat conduction layer 2a with an elastic force perpendicular to the contact surface of the heat generation mechanism 1 and the heat conduction layer 2a, and the heat conduction layer 2a is tightly pressed against the heat generation mechanism 1 by the elastic force.

In this embodiment, the substrate 11 may be a Printed Circuit Board (PCB). The PCB is a support for an electronic component and a carrier for electrical connection of the electronic component; several electronic components are arranged on the PCB, and the mutual electrical connection thereof is realized through the printed circuit on the PCB.

As shown in Fig. 10, the substrate 11 is fixedly connected to the heat dissipation mechanism 3, and the surface of the substrate 11 on which the electronic components are arranged is directly opposite to the heat dissipation mechanism 3. That is, as shown in Fig. 10, the electronic components on the substrate 11 are arranged between the substrate 11 and the heat dissipation mechanism 3.

The heat generation mechanism 1 is arranged between the substrate 11 and the heat transfer mechanism 3 and connected to the substrate 11. Here, the heat generation mechanism 1 may be a heating chip arranged on the substrate 11. The heat generation mechanism 1 is used as an electronic component and is arranged on the substrate 11 together with other electronic components, and is electrically connected to other electronic components through the printed circuit of the substrate 11.

In this embodiment, the heat conduction layer and the substrate are connected by a spring screw. The spring screw supplies an elastic force between the heat conduction layer and the substrate, so that the heat conduction layer is tightly pressed against the heat generation mechanism, thereby reducing the gap between the heat generation mechanism and the heat conduction layer, improving the transfer efficiency of heat generated by the heat generation mechanism to the heat dissipation mechanism, and enhancing the cooling and heat dissipation effect for the heat generation mechanism.

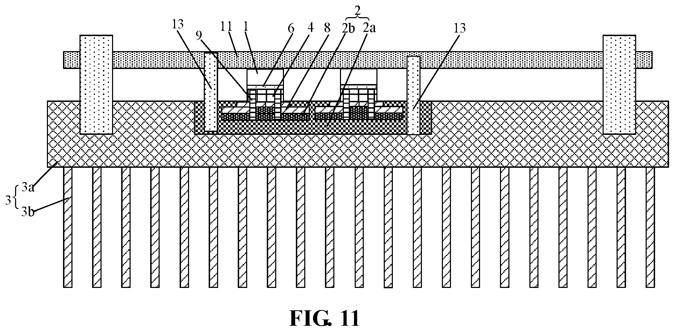

Based on the foregoing embodiments, as shown in Fig. 11 (in Fig. 11, a case where the heat dissipation mechanism includes two heat generation mechanisms is taken as an example), in an optional embodiment of the present disclosure, the heat generation mechanism 1 is arranged on the substrate 11; the heat dissipation mechanism also includes at least two second fixed connecting members, and the at least two second fixed connecting members fixedly connect the heat conduction layer 2a to the substrate 11.

In this embodiment, the second fixed connecting member 13 may be the same common screw as the first fixed connecting member, and the second fixed connecting member 13 fixes the heat conduction layer 2a on the substrate 11 through a threaded hole.

The second heat transfer layer may include thermal interface material with relatively soft fluidity, for example thermal interface material such as heat-conducting silicone grease and heat-conducting glue, and the thickness of the thermal interface material is 0.10mm to 0.15mm. The thermal interface material with relatively soft fluidity in this embodiment may be heat-conducting silicone grease, heat-conducting glue, etc. Certainly, the second heat transfer layer in this embodiment may be made of material the same as or different from the material of the filling layer, as long as it has high heat conductivity and a certain degree of elasticity, which is not particularly limited in this embodiment.

In various embodiments of the present disclosure, the filling layer is made of thermal interface material with a thickness of 0.30 mm to 1.00 mm. The filling layer in Figs. 1-8 may include elastic thermal interface material, and the filling layer in Figs. 9-11 may also be heat-conducting glue with relatively soft fluidity.

The heat conduction layer may include or may be a vapor chamber, and the vapor chamber has an area larger than the contact area of the heat generation mechanism and the heat conduction mechanism. The vapor chamber may be made of heat-conducting material with high heat conductivity, such as a copper plate, a VC plate, an aluminum plate or a heat pipe.

It should be understood that the first elastic connecting member 9 and the second elastic connecting member 12 in the above-mentioned embodiments and the filling layer 2b in Figs. 1-8 function as a floating mechanism that adjusts the gap between the layers by applying a clamping force. In particular, when the thermal interface material is used as the intermediate layer, through such a floating mechanism, the gap between the heat conduction layer 2a and the heat generation mechanism 1 and/or between the heat conduction layer 2a and the heat dissipation layer 3 can be reduced (i.e., the compression thickness of the interface material) to reduce heat resistance. Since the heat conduction layer 2a has the functions of heat conduction and temperature equalization, it can quickly extract heat from the heat generation mechanism, and quickly and fully transfer to the heat dissipation mechanism after the heat conduction and temperature equalization.

The above descriptions are only preferred embodiments of the present disclosure, and are not used to limit the protection scope of the present disclosure.

## Claims

1. A heat dissipation device, comprising a heat generation mechanism, a heat conduction mechanism and a heat dissipation mechanism, wherein the heat conduction mechanism comprises a heat conduction layer and a filling layer; wherein:
the heat generation mechanism is arranged on the heat dissipation mechanism;
the heat conduction mechanism is arranged between the heat generation mechanism and the heat dissipation mechanism, and the heat conduction mechanism is in contact with the heat generation mechanism and the heat dissipation mechanism, respectively;
the filling layer is not in contact with the heat generation mechanism; and the filling layer is elastic so that the heat conduction layer is tightly pressed against the heat generation mechanism by elastic floating; and
the filling layer is configured to transfer heat from the heat conduction layer to the heat dissipation mechanism.

2. The device according to claim 1, wherein the heat conduction layer is arranged between the filling layer and the heat generation mechanism.

3. The device according to claim 1 or 2, wherein,
the heat generation mechanism is arranged on a substrate;
the device further comprises at least two second elastic connecting members;
one end of each of the at least two second elastic connecting members is connected to the heat conduction layer and the other end of each of the at least two second elastic connecting members is connected to the substrate; and
the at least two second elastic connecting members are configured to supply an elastic force to the heat conduction layer in a direction toward to the heat generation mechanism.

4. The device according to claim 1 or 2, wherein,
the device further comprises at least two first fixed connecting members configured to fix the heat conduction layer on the heat dissipation mechanism.

5. The device according to claim 1 or 2, wherein:
the heat generation mechanism is arranged on a substrate;
the device further comprises at least two second fixed connecting members; and
the at least two second fixed connecting members are configured to fixedly connect the heat conduction layer to the substrate.

6. A heat dissipation device, comprising a heat generation mechanism, a heat conduction mechanism, a heat dissipation mechanism and a first heat transfer layer, wherein the heat conduction mechanism comprises a heat conduction layer and a filling layer; wherein:
the heat generation mechanism is arranged on the heat dissipation mechanism;
the heat conduction mechanism is arranged between the heat generation mechanism and the heat dissipation mechanism, and the heat conduction mechanism is in contact with the heat dissipation mechanism;
the first heat transfer layer is arranged on the heat conduction mechanism and configured to transfer heat from the heat generation mechanism to the heat conduction mechanism; and
the filling layer is not in contact with the heat generation mechanism.

7. The device according to claim 6, wherein:
a groove is formed on a surface of the heat conduction layer close to the first heat transfer layer; and
the first heat transfer layer is arranged in the groove.

8. The device according to claim 6, wherein:
the device further comprises at least two limiting columns;
the at least two limiting columns are arranged on the surface of the heat conduction layer close to the first heat transfer layer; and
the first heat transfer layer is arranged between the at least two limiting columns.

9. The device according to claim 6, wherein:
the device further comprises a second heat transfer layer; and
the second heat transfer layer is arranged on the first heat transfer layer and configured to transfer heat from the heat generation mechanism to the first heat transfer layer.

10. The device according to any one of claims 6 to 9, wherein:
the device further comprises a heat transfer member arranged between the first heat transfer layer and the filling layer;
the heat transfer member comprises a heat pipe;
an evaporation side of the heat pipe is connected to the first heat transfer layer; and
a condensation side of the heat pipe is connected to the heat conduction layer.

11. The device according to any one of claims 6 to 10, wherein:
the device further comprises at least one first elastic connecting member;
one end of the at least one first elastic connecting member is connected to the first heat transfer layer and the other end of the at least one first elastic connecting member is connected to the heat conduction layer; and
the at least one first elastic connecting member is configured to supply an elastic force to the first heat transfer layer in a direction toward to the heat generation mechanism.

12. The device according to any one of claims 6 to 11, wherein:
the filling layer is arranged between the heat conduction layer and the heat dissipation mechanism, and/or the filling layer (2b) is arranged between the heat conduction layer and the first heat transfer layer.

13. The device according to any one of claims 6 to 11, wherein:
the heat generation mechanism is arranged on a substrate;
the device further comprises at least two second elastic connecting members;
one end of the at least two second elastic connecting members is connected to the heat conduction layer and the other end of the at least two second elastic connecting members is connected to the substrate; and
the at least two second elastic connecting members are configured to supply an elastic force to the heat conduction layer in a direction toward to the heat generation mechanism.

14. The device according to any one of claims 6 to 11, wherein,
the device further comprises at least two first fixed connecting members configured to fix the heat conduction layer on the heat dissipation mechanism.

15. The device according to any one of claims 6 to 11, wherein:
the heat generation mechanism is arranged on a substrate;
the device further comprises at least two second fixed connecting members; and
the at least two second fixed connecting members are configured to fixedly connect the heat conduction layer to the substrate.

16. The device according to claim 9, wherein,
the filling layer and the second heat transfer layer are made of thermal interface material.

17. A heat dissipation device, comprising a heat generation mechanism, a heat conduction mechanism, a heat dissipation mechanism and a floating mechanism, the heat conduction mechanism comprising a heat conduction layer and a filling layer; wherein:
the heat conduction mechanism is arranged between the heat generation mechanism and the heat dissipation mechanism;
the filling layer is arranged between the heat conduction layer and the heat dissipation mechanism and configured to transfer heat from the heat conduction layer to the heat dissipation mechanism; and
the floating mechanism is configured to fixedly connect the heat conduction layer to the heat dissipation mechanism or the floating mechanism is configured to fixedly connect a substrate arranged on the heat generation mechanism to the heat conduction layer to reduce a gap between the heat generation mechanism and the heat conduction layer.

18. The heat dissipation device according to claim 17, wherein the filling layer is made of thermal interface material.

19. The heat dissipation device according to claim 17 or 18, wherein the heat conduction layer is made of a temperature-uniforming substrate, such as an aluminum plate, a copper plate, a vapor chamber plate, or an aluminum plate with embedded heat pipe.

20. The heat dissipation device according to any one of claims 17 to 18, wherein the floating mechanism is a spring screw.
